# EUROPÄISCHE PATENTANMELDUNG

(11) **EP 1 156 529 A2**
(43) Veröffentlichungstag der Anmeldung: **21.11.2001**
(21) Anmeldenummer: 01110454.4
(22) Anmeldetag: 27.04.2001
(51) Int. Cl.: H01L 25/065, H01L 23/495

(54) **Anordnung einer Mehrzahl von Schaltungsmodulen**

(30) Priorität: 16.05.2000 DE 10023869
(71) Anmelder: Infineon Technologies AG, 81669 München (DE)
(72) Erfinder: Hoegerl, Juergen, 93053 Regensburg (DE)
(74) Vertreter: MÜLLER & HOFFMANN Patentanwälte

(57) **Zusammenfassung**

Zur zuverlässigen und gleichwohl einfachen Verschaltung übereinander angeordneter Schaltungsmodule (2) wird bei einer entsprechenden Anordnung (1) vorgeschlagen, eine elektrische Verbindung verschiedener Verbindungseinrichtungen (5) der übereinander angeordneten Schaltungsmodule (2) jeweils durch direkten mechanischen und elektrischen Kontakt zwischen Verbindungselementen (6) verschiedener Verbindungseinrichtungen (5) auszubilden.

## Beschreibung

Die Erfindung betrifft eine Anordnung einer Mehrzahl von Schaltungsmodulen gemäß dem Oberbegriff des Anspruchs 1.

In der Schaltungstechnik und insbesondere in der Halbleiterelektronik besteht seit geraumer Zeit das Bestreben, Schaltungsanordnungen auszubilden, welche auf engstem Raum eine möglichst hohe Zahl von Bauelementen und/oder Schaltungsfunktionen realisieren. Demzufolge geht das Bestreben dahin, die entsprechenden Bauelemente und Schaltfunktionen im Rahmen des physikalisch möglichen immer weiter zu verkleinern. Da bestimmte physikalische Grenzen dabei nicht unterschritten werden können, ist damit zu rechnen, daß für jedes elektronische Bauelement zum einen eine auf physikalische Prinzipien beruhende kleinste Größe vorgegeben sein wird, daß zum anderen aber auch diese kleinste Größe unter Umständen nur mit einem erheblichen Kostenaufwand in der Massenproduktion realisiert werden kann.

Demzufolge wurden Auswege gesucht, die eine möglichst hohe Flächenausnutzung durch eine entsprechende Beschaltung gewährleisten. So ist vorgeschlagen worden, insbesondere bei Halbleitermodulen, Chips oder ganz allgemein bei Schaltungsmodulen, eine Mehrzahl der notwendigen Schaltungsmodule in vertikaler Richtung übereinandergeschichtet anzuordnen. Dieses sogenannte Stacking mehrerer Schaltungsmodule führt somit aus der zweidimensionalen Ebene und Packungsanordnung heraus und macht in vertikaler Richtung die dritte Dimension durch eine entsprechende Packung mehrerer Schaltungsmodule übereinander nutzbar.

Häufig ist es dabei notwendig, daß die übereinander angeordneten Schaltungsmodule miteinander verschaltet werden. Das bedeutet, daß die jeweils zur externen Kontaktierung der jeweiligen Schaltungsmodule notwendigen Verbindungseinrichtungen mit einer Mehrzahl von Verbindungselementen auch untereinander, d.h. also zwischen den zunächst elektrisch getrennten Schaltungsmodulen miteinander durch entsprechend vorzusehende Verbindungseinrichtungen zumindest teilweise elektrisch und schaltungstechnisch zu verbinden sind. Es wurden dazu verschiedene Konzepte vorgeschlagen, um die Verbindungseinrichtungen der jeweiligen Schaltungsmodule miteinander zu verschalten.

Im Stand der Technik ist es bekannt, daß man zum Beispiel Schaltungsmodule verschiedener Größen übereinander anordnet, so daß eine pyramidenstumpfartige Struktur von in vertikaler Richtung von unten nach oben in ihrer Grundfläche abnehmenden Schaltungsmodulen entsteht, welche dann als Stapel auf einem entsprechenden Träger angeordnet werden. Zur Verschaltung werden dann entsprechende Drahtbonds individuell von jedem Schaltungsmodul auf die Oberfläche des gemeinsamen Trägers heruntergeführt, wo dann auf einem entsprechenden leitfähigen Substrat die eigentliche Kontaktierung nach außen und der Module miteinander realisiert wird. Diese Vorgehensweise hat den Nachteil, daß zum einen Schaltungsmodule von unterschiedlicher Größe, d.h. Grundfläche, konzipiert werden müssen, so daß die Kombination identischer Module problematisch ist. Zum anderen müssen jeweils individuelle Drahtbonds ausgebildet und gezogen werden, was einer Automatisierung der Kontaktierung zwar nicht widerspricht, einen solchen automatischen Prozeß aber schwierig gestaltet.

Werden dagegen Schaltungsmodule identischer Größe übereinandergestapelt, so ist dennoch die Verschaltung der obenliegenden Schaltungsmodule mittels entsprechender Drahtbonds notwendig, selbst wenn das zuunterst angeordnete Schaltungsmodul zum Beispiel per Flip-Chip-Technologie auf dem gemeinsamen Träger befestigt und kontaktiert werden kann.

Um diese Problematiken zu umgehen, wurden auch andere Vorgehensweisen vorgeschlagen. Zum Beispiel ist in der US-PS 5,016,138 eine Anordnung einer Mehrzahl von Schaltungsmodulen offenbart, bei welcher die Schaltungsmodule im wesentlichen übereinander etwa in Form eines Stapels angeordnet sind. Zur externen Kontaktierung der Schaltungsmodule ist jeweils eine Verbindungseinrichtung mit einer Mehrzahl von Verbindungselementen vorgesehen. Im bekannten Stand der Technik gemäß der US-PS 5,016,138 ist diese Verbindungseinrichtung dadurch realisiert, daß die einzelnen Chips jeweils auf einen separaten Träger angeordnet sind, auf welchen dann die Kontakte der Chips durch eine aufgedruckte Schaltungsanordnung an den Rand des Trägers zu entsprechenden Kontaktstiften, die im Kantenbereich des Trägers angeordnet sind, herausgeführt werden. Die jeweiligen Gesamtheiten von Kontaktstiften werden dann über mehrere den Stapel seitlich umfassende Kontaktierungs- und Verschaltungsplatten miteinander kontaktiert und verschaltet.

Nachteilig bei dieser Vorgehensweise ist, daß jedes Schaltungsmodul wiederum auf einem Träger plaziert werden muß und daß die Verschaltung der verschiedenen Träger miteinander die Montage einer Vielzahl einzelner Komponenten erforderlich macht, weil ein inhärentes Verschalten der Module aus ihrem natürlichen Aufbau heraus hier nicht möglich ist.

Der Erfindung liegt die Aufgabe zugrunde, eine Anordnung einer Mehrzahl von Schaltungsmodulen anzugeben, bei welcher die Verschaltung der übereinander angeordneten Schaltungsmodule untereinander auf besonders zuverlässige und gleichwohl einfache und kostengünstige Art und Weise erfolgt.

Die Aufgabe wird erfindungsgemäß durch eine Anordnung einer Mehrzahl von Schaltungsmodulen mit den kennzeichnenden Merkmalen des Anspruchs 1 gelöst. Vorteilhafte Weiterbildungen der erfindungsgemäßen Anordnung einer Mehrzahl von Schaltungsmodulen ist Gegenstand der abhängigen Unteransprüche.

Bei der gattungsgemäßen Anordnung einer Mehrzahl von Schaltungsmodulen sind die Schaltungsmodule im wesentlichen übereinander etwa in Form eines Stapels angeordnet. Zur externen Kontaktierung der Schaltungsmodule ist jeweils eine Verbindungseinrichtung mit einer Mehrzahl von Verbindungselementen vorgesehen. Zwischen den Verbindungseinrichtungen der Schaltungsmodule wird zumindest teilweise eine elektrische Verbindung vorgesehen.

Die erfindungsgemäße Anordnung einer Mehrzahl von Schaltungsmodule ist dadurch gekennzeichnet, daß eine elektrische Verbindung verschiedener Verbindungseinrichtungen untereinander jeweils durch im wesentlichen unmittelbaren und direkten mechanischen und elektrischen Kontakt zwischen Verbindungselementen verschiedener Verbindungseinrichtungen ausgebildet ist.

Es ist somit eine Grundidee der vorliegenden Erfindung, bei einer Anordnung einer Mehrzahl von Schaltungsmodulen einen elektrischen Kontakt und somit eine Verschaltung der Schaltungsmodule dadurch zu erreichen, daß die Verbindungselemente der Schaltungsmodule, welche jede für sich eine entsprechende Verbindungseinrichtung des Schaltungsmoduls zur externen Kontaktierung bilden, im wesentlichen direkt und unmittelbar untereinander und ohne Zwischenschaltung oder Verwendung weiterer Kontakteinrichtungen erfolgt. Wenn also übereinander angeordnete Schaltungsmodule miteinander verschaltet werden müssen, so geschieht das erfindungsgemäß dadurch, daß die die Verbindungseinrichtungen der jeweiligen Schaltungsmodule bildenden Verbindungselemente so ausgebildet sind, daß sie miteinander im wesentlichen unmittelbar und direkt in Kontakt treten können. Der Unmittelbarkeit steht nicht entgegen, daß zur Kontaktierung und Fixierung ein Löt- oder Schweißmittel vorgesehen ist.

Eine derartige erfindungsgemäße Anordnung benötigt zur Kontaktierung der übereinander angeordneten Schaltungsmodule grundsätzliche keine zusätzlichen Bauteile, welche den Kontakt zwischen den einzelnen Verbindungselementen der Schaltungsmodule herstellen müßten. Dadurch wird die Montage vereinfacht und sicherer.

Besonders vorteilhaft gestaltet sich die erfindungsgemäße Anordnung einer Mehrzahl von Schaltungsmodulen, wenn die Verbindungselemente hinsichtlich ihrer geometrischen, mechanischen und/oder elektrischen Eigenschaften im wesentlichen gleichartig oder gleichwirkend ausgebildet sind. Gerade bei der Verwendung von im wesentlichen übereinstimmenden Schaltungsmodulen bietet es sich an, daß sämtliche Verbindungselemente, welche die Verbindungseinrichtung der jeweiligen Schaltungsmodule bilden, identisch ausgebildet sind, was einem Massenproduktionsprozeß entgegenkommt.

Vorzugsweise werden die Verbindungselementen jeweils als Verbindungsdraht ausgebildet, wobei dieser insbesondere sich im wesentlichen linear erstreckend geformt sein kann. Mit einem derartigen Verbindungselement in Form eines Verbindungsdrahtes können sämtliche Distanzen, zum Beispiel von einem Kontaktbereich auf irgendeiner Fläche des Schaltungsmoduls zu dessen Rand hin auf einfache Art und Weise überbrückt werden. Darüber hinaus haben Verbindungsdrähte hinsichtlich ihrer Formstabilität und mechanischen Haltbarkeit besonders günstige Eigenschaften. Sie lassen sich einfach herstellen, leicht formen, und sind doch widerstandsfähig genug, um bei einer automatischen Montage- und Bestückungsanlage verwendet zu werden.

Bei einer bevorzugten Ausführungsform weisen die Verbindungselemente, insbesondere die Verbindungsdrähte, jeweils ein erstes Ende auf, welches zum Kontaktieren mit dem jeweiligen Schaltungsmodul ausgebildet ist. Des weiteren ist ein zweites Ende vorgesehen, welches gegebenenfalls zum Kontaktieren mit mindestens einem anderen Verbindungselement eines anderen Schaltungsmoduls dienen kann. Ferner weist das Verbindungselement, insbesondere der Verbindungsdraht, einen Hauptbereich auf, welcher sich zwischen dem ersten Ende und dem zweiten Ende des Verbindungselements erstreckt und welcher insbesondere die Distanz der zu kontaktierenden Bereiche durchmißt.

Eine besonders einfache geometrische Anordnung sieht vor, daß die zweiten Enden der Verbindungselemente, insbesondere der Verbindungsdrähte, jeweils einen sich im wesentlichen linear und/oder sich im wesentlichen senkrecht zum Hauptbereich erstreckenden Bereich aufweisen. Das bedeutet, daß bei den Verbindungselementen jeweils der Hauptbereich und das zweite Ende zum Kontaktieren mit anderen Verbindungselementen anderer Schaltungsmodule im wesentlichen senkrecht aufeinander stehen. Dabei ist es von besonderem Vorteil, daß die Verbindungselemente, insbesondere die Verbindungsdrähte, vorzugsweise jeweils im wesentlichen die Form eines, insbesondere langgestreckten, Hakens, eines "L"s, einer Klaue oder dergleichen aufweisen. Des weiteren ist dabei bevorzugt, daß jeweils in einen Übergangsbereich zwischen dem Hauptbereich des Verbindungselements und dem ersten und/oder zweiten Ende des Verbindungselements eine Art Schulter oder dergleichen ausgebildet ist.

Aufgrund der vorstehenden Maßnahmen kann mit dem beschriebenen Verbindungselement auf besonders einfache Art und Weise auf der einen Seite ein Kontakt mit dem zu verschaltenden Schaltungsmodul hergestellt und auf der anderen Seite eine Verschaltung mit vertikal benachbarten Schaltungsmodulen realisiert werden, wobei die zuvor beschriebenen Schultern, insbesondere im zweiten Endbereich der Verbindungselemente, geeignet sind, einen Kontakt mit anderen Verbindungselementen auszubilden.

Bei der Montage der erfindungsgemäßen Anordnung einer Mehrzahl von Schaltungsmodulen müssen andauernde Deformationen, insbesondere der Verbindungselemente oder Verbindungseinrichtungen, vermieden werden. Da aber bei der Positionierung der mit den Verbindungselementen versehenen Schaltungsmodule eine gewisse Toleranz in der Positionierung und Bewegung der einzelnen Schaltungsmodule in vertikaler aber auch in horizontaler Richtung nicht ausgeschlossen werden kann, ist es von besonderem Vorteil, daß die Verbindungselemente der erfindungsgemäßen Anordnung einer Mehrzahl von Schaltungsmodulen, insbesondere die Verbindungsdrähte, insbesondere im Bereich der zweiten Enden, jeweils elastisch federnd ausgebildet sind. Durch diese Eigenschaft können die Verbindungselemente die Toleranzen beim Positionieren und die dadurch entstehenden mechanischen Insultien aufnehmen, ohne daß es zu Defekten in den Verbindungselementen selbst oder auch an den Kontaktstellen kommt.

Vorteilhafterweise wird eine erfindungsgemäße Anordnung einer Mehrzahl von Schaltungsmodulen gerade dadurch gebildet, daß die Schaltungsmodule hinsichtlich ihrer geometrischen, mechanischen und/oder elektrischen, insbesondere schaltungstechnischen Eigenschaften jeweils im wesentlichen gleichartig und/oder gleichwirkend ausgebildet sind.

Bekannterweise ergeben sich besonders raumsparende Anordnungen oder Stapel, wenn eine hohe Packungsdichte oder Stapeldichte erreicht werden kann. Erfahrungsgemäß setzt eine hohe Stapel- oder Packungsdichte insbesondere aber Gleichartigkeit in den geometrischen und mechanischen Eigenschaften voraus. Darüber hinaus ist es dabei eben auch von Vorteil, wenn die elektrischen Eigenschaften und insbesondere die Schaltungseigenschaften entsprechend aufeinander abgestimmt sind.

Vorzugsweise werden die Schaltungsmodule jeweils im wesentlichen flächig, schichtartig oder dergleichen und/oder im wesentlichen planar mit jeweils einer Oberseite und einer Unterseite ausgebildet. Dies ermöglicht ebenfalls eine besonders hohe Packungsdichte, die dann auf einfache Art und Weise erreicht werden kann, insbesondere im Rahmen eines automatischen Produktionsprozesses.

Vorzugsweise weisen die Schaltungsmodule jeweils mindestens einen Halbleiterchip, insbesondere eine Speichereinrichtung auf, und/oder sie sind als eine solche Einrichtung ausgebildet. Das Übereinanderstapeln von Speicherelementen hat den enormen Vorteil, daß man die schaltungstechnische Gleichartigkeit im wesentlichen identischer Schaltungsmodule ausnutzen kann. Gerade auch bei Speichereinrichtungen ist das Erzielen eines möglichst hohen Nutzungsgrads der Beschaltungsfläche erforderlich und wünschenswert. Dies kann aufgrund der erfindungsgemäßen Anordnung einer Mehrzahl von Schaltungsmodulen auf einfache Art und Weise erreicht werden.

Zur Kontaktierung der Schaltungsmodule mit ihren Verbindungseinrichtungen insbesondere mit den jeweiligen Verbindungselementen weisen die Schaltungsmodule jeweils mindestens einen Kontaktbereich auf, welcher insbesondere mit einer Mehrzahl von Kontakten zum externen Kontaktieren versehen ist. Bei Halbleitermodulen oder Chips werden diese Kontakte in der Regel durch sogenannte PADs realisiert, welche gerade die Kontaktstelle der internen Halbleiterstruktur mit der Außenwelt realisieren. Erfindungsgemäß ist es vorgesehen, daß die Verbindungselemente der Verbindungseinrichtung eines Schaltungsmoduls, insbesondere die ersten Enden davon, jeweils mit den Kontakten des Kontaktbereichs des jeweiligen Schaltungsmoduls kontaktiert sind.

Die Kontakte werden vorzugsweise durch metallische Bereiche auf den Schaltungsmodulen gebildet, und zwar vorzugsweise auf deren Unterseite und insbesondere durch sogenannte PADs. Insbesondere bei Speicherbausteinen hat es sich durchgesetzt und ist es von Vorteil, daß die Kontaktbereiche jeweils an einer Unterseite des Schaltungsmoduls jeweils in einem im wesentlichen zentralen Bereich davon ausgebildet sind. Im industriellen Standard spricht man auch von sogenannten Center PAD Chips (CPC).

Bei der Ausgestaltung der Verbindungseinrichtungen haben sich bestimmte Ausgestaltungsformen als besonders vorteilhaft erwiesen. So ist es vorgesehen, daß die Verbindungseinrichtung mindestens eine Reihenanordnung, insbesondere äquidistant beabstandeter, parallel und/oder bündig ausgerichteter und/oder gleich orientierter Verbindungselemente, vorzugsweise entlang mindestens eines Kantenbereichs des jeweiligen Schaltungsmoduls ausgerichtet, aufweist. So ist es von besonderem Vorteil, daß zum Beispiel Verbindungsdrähte in gleicher Form und Länge parallel zueinander und bündig - nach Art eines Kammes - ausgerichtet angeordnet werden.

Bevorzugt wird, daß die Verbindungseinrichtung zwei Reihenanordnungen von Verbindungselementen aufweist und daß die Reihenanordnung, insbesondere die Verbindungselemente davon, jeweils lateral miteinander koinzidierend oder zueinander auf Lücke angeordnet sind, wobei die Reihenanordnungen vorzugsweise im wesentlichen in einer gemeinsamen Ebenen liegen und im wesentlichen spiegelsymmetrisch zu einer in dieser Ebene liegenden Achse angeordnet sind.

Dadurch wird erreicht, daß sich die beiden Reihenanordnungen von Verbindungselementen so gegenüberstehen, daß die jeweils ersten Enden der Verbindungselemente der Reihen einander zugewandt sind und daß die zweiten Enden - zum externen Kontaktieren - jeweils voneinander maximal entfernt sind. Durch das Anordnen auf Lücke oder koinzidierend kann der jeweiligen Anordnung der Kontakte auf der Unterseite des Schaltungsmoduls Rechnung getragen werden.

Die Verbindungselemente oder Verbindungsdrähte bilden z. B. Kontaktierungsbeinchen, welche bei koinzidierender Anordnung im wesentlichen kollinear ausgerichtet sind. Dabei erstreckt sich jede der Reihenanordnungen zum Beispiel entlang einer Kante des zugehörigen Schaltungsmoduls, so daß zwei gegenüberliegende Kanten frei bleiben, während entlang der beiden anderen sich gegenüberliegenden Kanten des Schaltungsmoduls die zwei Reihenanordnungen von Verbindungselementen zumindest teilweise verlaufen.

Bei einer anderen vorteilhaften Ausführungsform der erfindungsgemäßen Anordnung einer Mehrzahl von Schaltungsmodulen weist die Verbindungseinrichtung jeweils vier Reihenanordnungen von Verbindungselementen auf. Diese vier Reihenanordnungen sind jeweils im wesentlichen entlang mindestens eines Kantenbereichs angeordnet und liegen sich paarweise gegenüber. So wird zum Beispiel bei einem Schaltungsmodul mit quadratischer oder rechteckiger Grundfläche erreicht, daß sich jeweils eine Reihe von Verbindungselementen entlang einer Kante des Schaltungsmoduls erstreckt. Auf diese Weise kann eine besonders hohe Zahl von Verbindungseinrichtungen ausgebildet werden.

Auch dabei ist es vorgesehen, daß die Mehrzahl von Reihenanordnungen, insbesondere die Verbindungselemente davon, im wesentlichen in einer gemeinsamen Ebene liegen. Dabei ist es ferner vorgesehen, daß die jeweils sich gegenüberstehenden Reihenanordnungen, insbesondere die Verbindungselemente davon, spiegelsymmetrisch zu einer Achse in dieser Ebene ausgerichtet sind. Die einzelnen Verbindungselemente der sich gegenüberstehenden Reihenanordnungen sind dann wieder kollinear oder koinzidierend ausgerichtet oder die Verbindungselemente stehen auf Lücke zueinander.

Die Reihenanordnungen können zwar jeweils von einzelnen und getrennten Verbindungselementen gebildet werden. Vorteilhafterweise werden die Reihenanordnungen aber jeweils von einem Verband von Verbindungselementen gebildet, welche auf einem Verbindungsträger angeordnet und/oder dort fixiert sind. Dabei kann als Verbindungsträger vorzugsweise ein, insbesondere doppelseitiges, haftendes oder klebendes Medium, insbesondere als Band, ausgebildet sein, wobei die einzelnen Verbindungselemente dort insbesondere aufbringbar und/oder einbettbar sind. So kann tatsächlich an einer Art doppelseitiges Klebeband oder auch an eine entsprechende Einbett- oder Klebemasse gedacht werden.

Zur Kontaktierung und Verschaltung der übereinander angeordneten Schaltungsmodule untereinander ist es erfindungsgemäß vorgesehen, daß die Reihenanordnungen direkt und unmittelbar übereinander vorgesehene Schaltungsmodule zumindest teilweise im wesentlichen vertikal koinzidierende Verbindungselemente aufweisen. Somit können auf besonders einfache Art und Weise die unmittelbar in Nachbarschaft befindlichen Verbindungselemente der direkt übereinander angeordneten Schaltungsmodule miteinander in Kontakt gebracht werden, um so eine Verschaltung der Schaltungsmodule zu bewirken.

Dabei ist es von Vorteil, daß zumindest ein Teil der vertikal koinzidierenden Verbindungselemente direkt und unmittelbar übereinander vorgesehener Schaltungsmodule, insbesondere hinsichtlich ihrer Orientierung, ihrer geometrischen Abmessung und/oder dergleichen, derart ausgebildet sind, um miteinander mechanisch und elektrisch kontaktiert zu werden, wobei insbesondere jeweils ein Verbindungselement eines vertikal höher angeordneten ersten Schaltungsmoduls mit seinem zweiten Ende im Bereich einer Schulter oder des zweiten Endes des jeweiligen vertikal koinzidierenden Verbindungselements des vertikal direkt darunter angeordneten zweiten Schaltungsmoduls kontaktierbar ist.

Dies wird insbesondere dadurch besonders einfach realisiert, daß der mechanische und elektrische Kontakt der Verbindungselemente jeweils durch Lötung, Schweißung, insbesondere Laserschweißung, und/oder aufgrund eines Kraftschlusses mit Federvorspannung im Bereich der zweiten Enden der Verbindungselemente ausgebildet wird.

Zur besseren Handhabung und zur Kontaktierung und Verwendung der erfindungsgemäßen Anordnung einer Mehrzahl von Schaltungsmodulen ist ein Träger vorgesehen, auf welchem das unterste der in vertikaler Richtung übereinander angeordneten Schaltungsmodule angeordnet, fixiert und/oder elektrisch kontaktiert ist. Ferner ist es vorteilhafterweise vorgesehen, daß eine Gehäuseeinrichtung, insbesondere in Form einer Vergußmasse ausgebildet ist, in welcher zumindest die Schaltungsmodule aufnehmbar sind. Durch diese Maßnahmen wird sichergestellt, daß die Anordnung der Mehrzahl von Schaltungsmodulen als Ganzes auf einfache Art und Weise gehandhabt werden kann. Dabei kann der vorgesehene Träger auch eine entsprechende Verschaltung und Kontaktierung, zum Beispiel zum Einbau in eine übergeordnete Einrichtung, aufweisen.

Die im Stand der Technik vorgesehene Anordnung von Schaltungsmodulen hat den Nachteil, daß Kompromisse hinsichtlich der zu verwendenden Schaltungsmodule getroffen werden müssen oder aber daß ein erheblicher Aufwand zur Verbindung der Schaltungsmodule untereinander in Kauf genommen werden müssen.

Insbesondere beim Übereinanderanordnen von sogenannten Center PAD Chips, insbesondere in einem sogenannten Chip-Scale-Package, sind diese Nachteile nicht in Kauf zu nehmen. Bei der erfindungsgemäßen Anordnung einer Mehrzahl von Schaltungsmodulen werden diese Nachteile dadurch vermieden, daß ein grundsätzliches Verbindungskonzept für alle übereinander angeordneten Schaltungsmodule gemeinsam greift. Durch die erfindungsgemäße Ausbildung ist das Herausführen der elektrischen Anschlüsse zum Rand der Schaltungsanordnung und um die Schaltungsanordnung herum mittels der jeweiligen Verbindungseinrichtungen oder Verbindungselemente auf einfache Art und Weise möglich. So lassen sich einheitliche Einzelkomponenten, nämlich die Schaltungsmodule, herstellen, die sich dann übereinander montieren und anordnen lassen, und das in besonders einfacher und der Automatisierung zugänglicher Art und Weise. Der elektrische Anschluß wird jeweils durch das Überlappen und die dauerhafte Verbindung der Verbindungselemente oder Verbindungsdrähte (interconnector leads) erreicht. Die Verbindungsdrähte oder Verbindungselemente können entweder einzeln aufgebracht werden oder auch als strukturiertes Flex-Tape ausgeführt sein.

Auf diese Art und Weise lassen sich auch mehr als zwei Schaltungsmodule oder Chips übereinander montieren. Darüber hinaus besteht auf einfache Art und Weise grundsätzlich die Möglichkeit, defekte Komponenten aus dem Stapel übereinander angeordneter und miteinander verschalteter Schaltungsmodule herauszulösen.

Nachfolgend wird die Erfindung anhand einer schematischen Zeichnung auf der Grundlage bevorzugter Ausführungsbeispiele der erfindungsgemäßen Anordnung einer Mehrzahl von Schaltungsmodulen näher erläutert. In dieser Zeichnung zeigt:
- Fig. 1: eine schematische, teilweise geschnittene Seitenansicht eines Schaltungsmoduls zur Verwendung in einer Ausführungsform der erfindungsgemäßen Anordnung einer Mehrzahl von Schaltungsmodulen,
- Fig. 2: eine Teilansicht von unten auf das Schaltungsmodul aus Fig. 1,
- Fig. 3: eine Teilansicht von unten auf ein anderes Schaltungsmodul,
- Fig. 4: eine schematische Seitenansicht eines Verbindungselements, wie es in einem Ausführungsbeispiel der erfindungsgemäßen Anordnung einer Mehrzahl von Schaltungsmodulen verwendet wird,
- Fig. 5: eine perspektivische Ansicht auf die Unterseite des Schaltungsmoduls aus Fig. 1 und
- Fig. 6: eine teilweise geschnittene Seitenansicht auf ein anderes Ausführungsbeispiel der erfindungsgemäßen Anordnung einer Mehrzahl von Schaltungsmodulen.

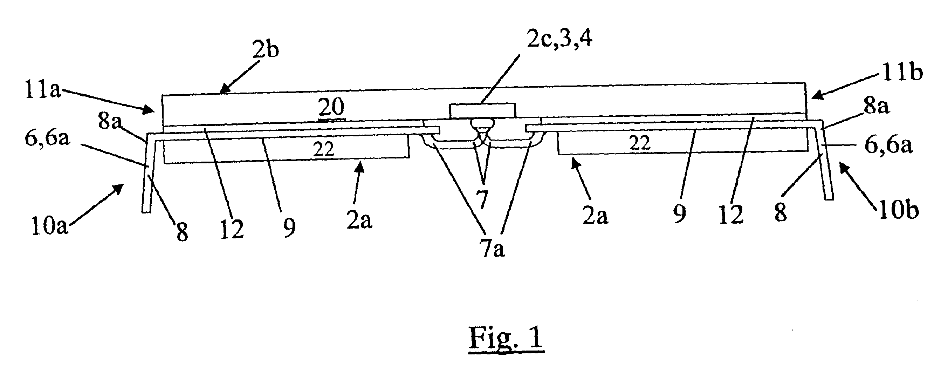

Fig. 1 zeigt in schematischer und teilweise geschnittener Seitenansicht ein Schaltungsmodul 2, wie es in einem Ausführungsbeispiel der erfindungsgemäßen Anordnung einer Mehrzahl von Schaltungsmodulen 2 verwendet wird.

Das Schaltungsmodul 2 besteht in diesem Fall im wesentlichen aus einem Chip 20, welcher zum Beispiel auch in ein entsprechendes Substrat eingegossen sein kann. Das Schaltungsmodul 2 hat im wesentlichen eine flache, plattenartige und quaderförmige Gestalt und weist Kanten- oder Seitenbereiche 11a und 11b auf. Während die Oberseite 2b des Schaltungsmoduls 2 frei bleibt, ist auf der Unterseite 2a des Schaltungsmoduls die Verbindungseinrichtung 5 zum externen Kontaktieren ausgebildet.

Die Verbindungseinrichtung 5 besteht aus zwei Reihenanordnungen 10a und 10b von jeweils auf einem Verbindungsträger 12 ausgebildeten Verbindungselementen 6.

Die Verbindungselemente 6 weisen jeweils einen Hauptbereich 9, einen ersten Endbereich 7 sowie einen zweiten Endbereich 8 auf. Die Endbereiche 7 sind jeweils dazu ausgebildet, um mit einem Kontaktbereich 3 des Schaltungsmoduls 2 und dort insbesondere mit Kontakten 4 verbunden zu werden. Dagegen sind die zweiten Enden 8 der Verbindungselemente 6 zum Kontaktieren mit anderen Verbindungselementen 6 anderer Schaltungsmodule 2 vorgesehen. Dazu weisen die Verbindungselemente 6 im Übergangsbereich zwischen dem Hauptbereich 9 und dem zweiten Ende 8 jeweils eine Schulter 8a auf. Auch im Übergangsbereich zwischen Hauptbereich 9 und dem ersten Ende des Verbindungselements 6 ist jeweils ein Schulterbereich 7a vorgesehen.

Zur geeigneten Beabstandung der übereinander anzuordnenden Schaltungsmodule 2 ist auf der Unterseite 2a des Schaltungsmoduls 2 jeweils ein sogenanntes Abstandselement 22 ausgebildet.

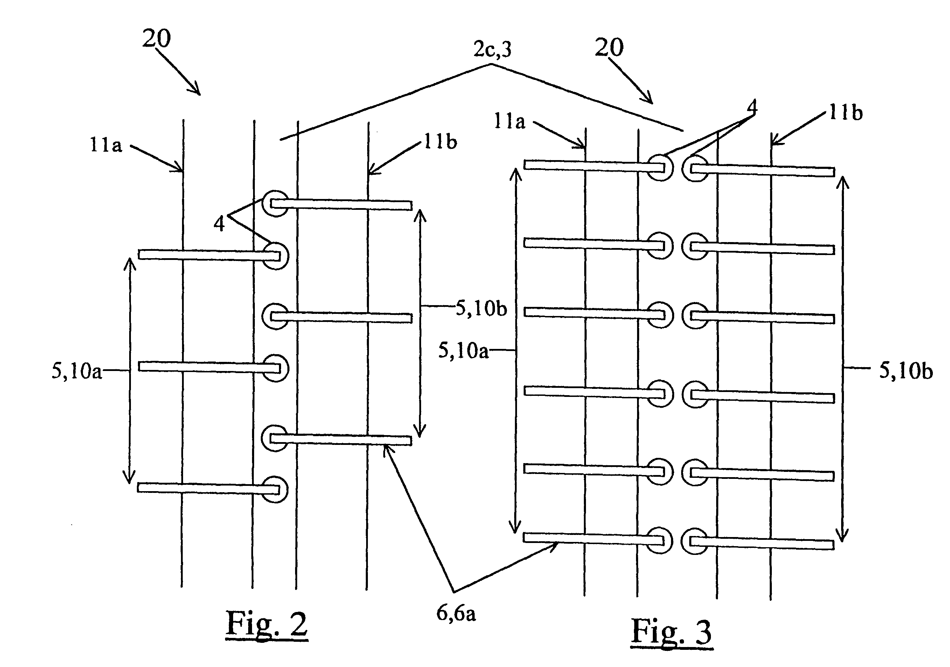

In der Fig. 2 ist die Unterseite 2a des in Fig. 1 gezeigten Schaltungsmoduls 2 unter Fortlassung der Abstandselemente 22 dargestellt.

In einem zentralen Bereich 2c der Unterseite 2a des Schaltungsmoduls 2 ist der Kontaktbereich 3 ausgebildet, der eine Mehrzahl von Kontakten 4 aufweist. Von den Kontakten 4 ausgehend, erstrecken sich Verbindungselemente 6 in Form von Verbindungsdrähten 6a, wobei die Verbindungsdrähte 6a mit ihren ersten Enden 7 an den Kontakten 4 kontaktiert sind. Vom zentralen Bereich 2c auf der Unterseite 2a ausgehend, erstrecken sich dann die Drähte 6a linear auf die Kantenbereiche 11a und 11b hin, wo sie in ihre zweiten Enden 8 auslaufen, welche sich senkrecht nach oben aus der Ebene der Zeichnung heraus erstrecken.

Die Verbindungselemente 6 oder die Verbindungsdrähte 6a der Verbindungseinrichtungen 5, welche zu den Kantenbereichen 11a und 11b des Schaltungsmoduls 2 gehören, sind jeweils als auf Lücke und bündig angeordnete Reihenanordnungen 10a und 10b ausgebildet. Alternierend verlaufen die Verbindungsdrähte 6a nach rechts außen oder nach links außen zum Kantenbereich 11b bzw. 11a des Schaltungsmoduls 2.

In der Fig. 3 ist dargestellt, daß die Verbindungselemente 6 bzw. 6a der Reihenanordnungen 10a und 10b auch koinzidierend ausgerichtet sein können, wobei dann im zentralen Bereich 2c der Unterseite 2a des Schaltungsmoduls 2 zwei nebeneinander liegende Reihen von Kontakten 4 im Kontaktbereich 3 des Schaltungsmoduls 2 vorgesehen sind.

Ansonsten ist der in Fig. 3 gezeigte Aufbau mit dem in Fig. 2 gezeigten Aufbau identisch.

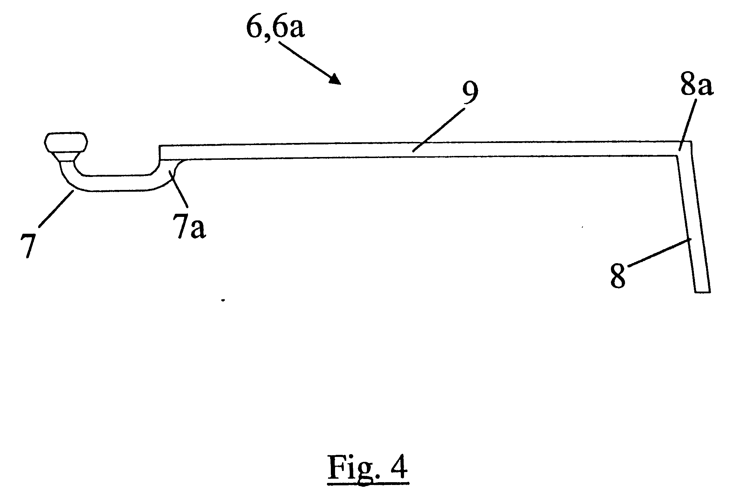

In der Fig. 4 ist in schematischer und teilweise geschnittener Seitenansicht ein Verbindungselement 6 oder ein Verbindungsdraht 6a gezeigt, wie er in dem in Fig. 1 gezeigten Schaltungsmodul 2 zum externen Kontaktieren von Schaltungsmodulen 2 untereinander verwendet wird.

Der Verbindungsdraht 6a oder das Verbindungselement 6 wird im wesentlichen von einem sich linear erstreckenden Hauptbereich 9 gebildet. Der Verbindungsdraht 6a weist ein erstes Ende 7 auf, welches vom Hauptbereich 9 des Verbindungsdrahts 6a aus einem ersten Schulterbereich 7a entspringt. Dem ersten Ende 7 gegenüberliegend ist ein zweite Ende 8 ausgebildet, welches aus dem Hauptbereich 9 des Verbindungsdrahts 6a aus einem zweiten Schulterbereich 8a entspringt. Das zweite Ende 8a wird von einem sich im wesentlichen linearen Drahtabschnitt gebildet, welcher im wesentlichen senkrecht zum Hauptbereich 9 des Verbindungsdrahts 6a ausgebildet ist. Insgesamt gesehen hat der Verbindungsdraht 6a in diesem Ausführungsbeispiel im wesentlichen die Form eines langgestreckten Hakens, einer Klaue oder eines "L".

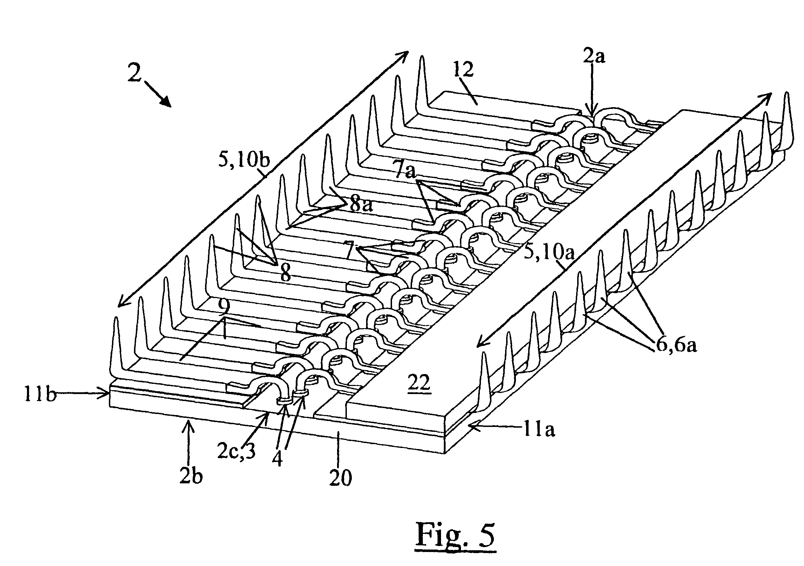

Zur besseren Veranschaulichung der Ausbildung des in der erfindungsgemäßen Anordnung zu verwendenden Schaltungsmoduls 2 ist in Fig. 5 dieses Schaltungsmodul 2 aus Fig. 1 in einer perspektivischen Ansicht von unten dargestellt, wobei eines der Abstandselemente 22 zur besseren Veranschaulichung fortgelassen wurde.

Wiederum besteht das Schaltungsmodul 2 aus einer Schaltungsanordnung 20, welche gegebenenfalls in einer entsprechenden Vergußmasse aufgenommen ist. Die Oberseite der SchaltungsanOrdnung 20 bildet somit auch die Oberseite 2b des Schaltungsmoduls 2. Die Unterseite 2a des Schaltungsmoduls 2 wird im wesentlichen von der Verbindungseinrichtung 5 gebildet, welche zwei Reihenanordnungen 10a und 10b von Verbindungselementen 6 bzw. Verbindungsdrähten 6a aufweist.

Die Verbindungselemente 6 oder Verbindungsdrähte 6a weisen wiederum die Form eines langgestreckten Hakens oder einer Klaue oder eines "L" auf, wobei ein sich linear erstreckender Hauptbereich 9 mit einem ersten Ende 7 und einem zweiten Ende 8 vorgesehen ist.

Die Mehrzahl der Verbindungselemente 6 oder Verbindungsdrähte 6a der beiden Reihenanordnungen 10a und 10b sind hier gegeneinander versetzt auf Lücke angeordnet und verlaufen mit ihren ersten Enden 7 im Bereich der Kontakte 4 des Kontaktbereichs 3 im zentralen Bereich 2c der Unterseite 2a des Schaltungsmoduls 2 ausgehend senkrecht auf die Randbereiche 11a und 11b des Schaltungsmoduls 2 zu. An den Randbereichen 11a und 11b des Schaltungsmoduls 2 sind dann im wesentlichen die zweiten Enden 8 der Verbindungselemente 6 oder der Verbindungsdrähte 6a ausgebildet, wobei die zweiten Enden 8, welche im wesentlichen senkrecht auf den Hauptbereichen 9 der Verbindungsdrähte 6a stehen, so ausgerichtet sind, daß sie von der Schaltungsanordnung 20 und der Oberseite oder Oberfläche 2b des Schaltungsmoduls 2 wegzeigen.

Zur entsprechenden Beabstandung der übereinander anzuordnenden Schaltungsmodule 2 ist jeweils ein Abstandselement 22 vorgesehen, welches die Reihenanordnung 10a bzw. 10b von der Unterseite her abdeckt. Die Reihenanordnungen 10a und 10b sind jeweils auf einem Verbindungsträger 12, zum Beispiel in Form eines Flex-Tapes, angeordnet und dort befestigt.

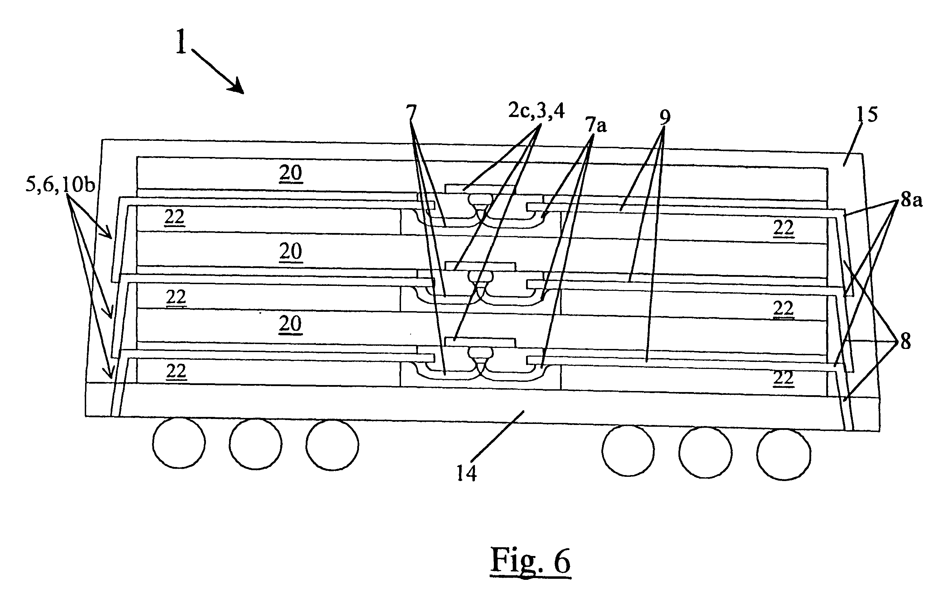

Die Fig. 6 schließlich zeigt in schematischer und teilweise geschnittener Seitenansicht ein Ausführungsbeispiel der erfindungsgemäßen Anordnung einer Mehrzahl von Schaltungsmodulen.

In dieser Ausführungsform sind drei Schaltungsmodule 2 von identischem geometrischem Aufbau auf einem Träger 14 übereinander angeordnet. Die Schaltungsmodule 2 werden voneinander bzw. vom Träger 14 durch entsprechend vorgesehene Abstandselemente 22 getrennt.

Jedes der Schaltungsmodule 2 weist eine Schaltungsanordnung 20 auf, welche in einer entsprechenden Vergußmasse eingelassen sein kann. Die Oberseite 2b eines Schaltungsmoduls 2, welches in vertikaler Ausrichtung tiefer angeordnet ist, steht dabei jeweils in Kontakt mit der Unterseite 2a des in vertikaler Richtung nach oben nachfolgenden Schaltungsmoduls 2, wobei das unterste Schaltungsmodul 2 mit seiner Unterseite 2a bzw. den entsprechenden Abstandselementen 22 auf der Oberseite des Trägers 14 aufliegt und dort kontaktiert ist und wobei die Oberseite 2b des obersten Schaltungsmoduls 2 frei bleibt bzw. in direktem Kontakt mit dem Gehäusematerial der Gehäuseeinrichtung 15 steht.

Die Abstandselemente 22 können zusätzlich als Mittel zum Entwärmen der übereinander gestapelten Schaltungsmodule 2 dienen. Dazu sind diese dann aus einem den Wärmetransport fördernden Material gestaltet und stehen zur Vergrößerung ihrer Oberfläche vorzugsweise an den Kantenbereichen über, welche nicht mit Kontaktelementen besetzt sind.

Wie aus der Fig. 5 zu ersehen ist, stehen die Verbindungselemente 6 oder Verbindungsdrähte 6a eines in vertikaler Richtung oben angeordneten Schaltungsmoduls 2 mit ihren zweiten Enden 8 in mechanischem und elektrischem Kontakt mit den Verbindungseinrichtungen 6 oder Verbindungsdrähten 6a des in vertikaler Richtung jeweils direkt darunter angeordneten Schaltungsmoduls 2, und zwar insbesondere in den sogenannten Schulterbereichen 8a der Verbindungselemente 6 oder Verbindungsdrähte 6a. Die Verbindungsdrähte 6 oder Verbindungselemente 6a des zuunterst angeordneten Schaltungsmoduls 2 sind dann direkt auf dem Träger 14 befestigt und kontaktiert und realisieren somit die externe Verschaltung, zum Beispiel in einer übergeordneten Schaltungseinrichtung oder Anwendung.

## Patentansprüche

1. Anordnung einer Mehrzahl von Schaltungsmodulen, bei welcher:
- die Schaltungsmodule (2) im wesentlichen übereinander etwa in Form eines Stapels angeordnet sind,
- zur externen Kontaktierung der Schaltungsmodule (2) jeweils eine Verbindungseinrichtung (5) vorgesehen ist,
- zwischen den Verbindungseinrichtungen (5) der Schaltungsmodule (2) zumindest teilweise eine elektrische Verbindung vorgesehen ist, und
- eine elektrische Verbindung verschiedener Verbindungseinrichtungen (5) untereinander jeweils durch im wesentlichen unmittelbaren und direkten mechanischen und elektrischen Kontakt verschiedener Verbindungseinrichtungen (5) ausgebildet ist
**dadurch gekennzeichnet,**
- **daß** die Verbindungseinrichtung (5) jeweils mindestens eine im wesentlichen in einer Ebene ausgebildete Reihenanordnung (10a-d) einer Mehrzahl von Verbindungselementen (6) aufweist und
- **daß** die Mehrzahl von Verbindungselementen (6) auf einem Verbindungsträger (12) angeordnet und/oder fixiert ausgebildet sind.

2. Anordnung nach Anspruch 1,
**dadurch gekennzeichnet,**
**daß** die Verbindungselemente (6) hinsichtlich ihrer geometrischen, mechanischen und/oder elektrischen Eigenschaften im wesentlichen gleichartig oder gleichwirkend ausgebildet sind.

3. Anordnung nach einem der vorangehenden Ansprüche,
**dadurch gekennzeichnet,**
**daß** die Verbindungselemente (6) jeweils als Verbindungsdrähte (6a) ausgebildet sind.

4. Anordnung nach Anspruch 3,
**dadurch gekennzeichnet,**
**daß** die Verbindungsdrähte (6a) jeweils als sich im wesentlichen linear erstreckend ausgebildet sind.

5. Anordnung nach einem der vorangehenden Ansprüche,
**dadurch gekennzeichnet,**
**daß** die Verbindungselemente (6), insbesondere die Verbindungsdrähte (6a), jeweils ein erstes Ende (7) zum Kontaktieren mit dem jeweiligen Schaltungsmodul (2), ein zweites Ende (8) ggf. zum Kontaktieren mit mindestens einem Verbindungselement (6) eines anderen Schaltungsmoduls sowie einen sich zwischen diesen Enden (7, 8) erstreckenden Hauptbereich (9) aufweisen.

6. Anordnung nach einem der vorangehenden Ansprüche,
**dadurch gekennzeichnet,**
**daß** die zweiten Enden (8) der Verbindungselemente (6), insbesondere der Verbindungsdrähte (6a), jeweils einen sich im wesentlichen linear und/oder sich im wesentlichen senkrecht zum Hauptbereich (9) erstreckenden Bereich aufweisen.

7. Anordnung nach einem der vorangehenden Ansprüche,
**dadurch gekennzeichnet,**
**daß** die Verbindungselemente (6), insbesondere die Verbindungsdrähte (6a), jeweils im wesentlichen die Form eines, insbesondere langgestreckten, Hakens, "L"s, einer Klaue oder dergleichen aufweisen, wobei vorzugsweise im Übergang zwischen Hauptbereich (9) und erstem und/oder zweitem Ende (7, 8) eine Art Schulter (7a, 8a) oder dergleichen ausgebildet ist.

8. Anordnung nach einem der vorangehenden Ansprüche,
**dadurch gekennzeichnet,**
**daß** die Verbindungselemente (6), insbesondere die Verbindungsdrähte (6a), insbesondere im Bereich der zweiten Enden (8), jeweils elastisch federnd ausgebildet sind.

9. Anordnung nach einem der vorangehenden Ansprüche,
**dadurch gekennzeichnet,**
**daß** die Schaltungsmodule (2) hinsichtlich ihrer geometrischen, mechanischen und/oder elektrischen und insbesondere Schaltungseigenschaften jeweils im wesentlichen gleichartig und/oder gleichwirkend ausgebildet sind.

10. Anordnung nach einem der vorangehenden Ansprüche,
**dadurch gekennzeichnet,**
**daß** die Schaltungsmodule (2) jeweils im wesentlichen flächig, schichtartig oder dergleichen und/oder im wesentlichen planar mit einer Oberseite (2a) und einer Unterseite (2b) ausgebildet sind.

11. Anordnung nach einem der vorangehenden Ansprüche,
**dadurch gekennzeichnet,**
**daß** die Schaltungsmodule (2) jeweils mindestens einen Halbleiterchip, insbesondere als Speichereinrichtung, aufweisen und/oder als solche ausgebildet sind.

12. Anordnung nach einem der vorangehenden Ansprüche,
**dadurch gekennzeichnet,**
- **daß** die Schaltungsmodule (2) jeweils mindestens einen Kontaktbereich (3) mit einer Mehrzahl von Kontakten (4) zum externen Kontaktieren aufweisen und
- **daß** Verbindungselemente (6) der Verbindungseinrichtung (5) eines Schaltungsmoduls (2), insbesondere die ersten Enden (7) davon, jeweils mit mindestens einem Kontakt (4) des Kontaktbereichs (3) des jeweiligen Schaltungsmoduls (2) kontaktiert sind.

13. Anordnung nach einem der vorangehenden Ansprüche,
**dadurch gekennzeichnet,**
**daß** als Kontakte (4) metallische Bereiche auf den Schaltungsmodulen (2), insbesondere sogenannte PADs, vorgesehen sind.

14. Anordnung nach einem der vorangehenden Ansprüche,
**dadurch gekennzeichnet,**
**daß** die Kontaktbereiche (3) jeweils an einer Unterseite (2b) des Schaltungsmoduls (2) jeweils in einem im wesentlichen zentralen Bereich (2c) davon ausgebildet sind.

15. Anordnung nach einem der vorangehenden Ansprüche,
**dadurch gekennzeichnet,**
**dass** die Verbindungselemente (6) der Reihenanordnung (10a-d) jeweils äquidistant beabstandet, parallel und/oder bündig ausgerichtet und/oder gleichorientiert, vorzugsweise entlang mindestens eines Kantenbereichs (11a-d) des jeweiligen Schaltungsmoduls (2) ausgerichtet sind.

16. Anordnung nach Anspruch 15,
**dadurch gekennzeichnet,**
- **daß** die Verbindungseinrichtung (5) zwei Reihenanordnungen (10a-d) von Verbindungselementen (6) aufweist,
- **daß** die Reihenanordnungen (10a-d), insbesondere die Verbindungselemente (6) davon, lateral miteinander koinzidierend oder zueinander auf Lücke angeordnet sind, und
**daß** insbesondere die Reihenanordnungen (10a-d) im wesentlichen in einer gemeinsamen Ebene liegen und im wesentlichen spiegelsymmetrisch zu einer im wesentlichen in dieser Ebene liegenden Achse ausgerichtet sind.

17. Anordnung nach einem der Ansprüche 15 oder 16,
**dadurch gekennzeichnet,**
- **daß** die Verbindungseinrichtung (5) jeweils vier Reihenanordnungen (10a-d) von Verbindungselementen (6) aufweist und
- **daß** die Reihenanordnungen (10a-d), insbesondere die Verbindungselemente (6) davon, jeweils im wesentlichen entlang mindestens eines Kantenbereichs (11a-d) sich paarweise gegenüberliegend angeordnet sind, und
- **daß** insbesondere die Reihenanordnungen (10a-d) im wesentlichen in einer gemeinsamen Ebene liegen und je zwei sich gegenüberliegende Reihenanordnungen (10a-d) jeweils spiegelsymmetrisch zu einer im wesentlichen in der gemeinsamen Ebene liegenden Achse ausgerichtet sind.

18. Anordnung nach einem der Ansprüche 15 bis 17,
**dadurch gekennzeichnet,**
**daß** die Reihenanordnung (10a-d) jeweils von einzelnen, getrennten Verbindungselementen (6) und/oder von einem Verband von Verbindungselementen (6) gebildet werden.

19. Anordnung nach Anspruch 18,
**dadurch gekennzeichnet,**
**daß** der Verbindungsträger (12) als, vorzugsweise doppelseitiges, haftendes oder klebendes Medium, vorzugsweise als Band, ausgebildet ist, auf oder in welches die Verbindungselemente (6) aufbringbar oder einbettbar sind.

20. Anordnung nach einem der Ansprüche 15 bis 19,
**dadurch gekennzeichnet,**
**daß** die Reihenanordnungen (10a-d) direkt und unmittelbar übereinander vorgesehener Schaltungsmodule (2) zumindest teilweise im wesentlichen vertikal koinzidierende Verbindungselemente (6) aufweisen.

21. Anordnung nach Anspruch 20,
**dadurch gekennzeichnet,**
**daß** zumindest ein Teil der vertikal koinzidierenden Verbindungselemente (6) direkt und unmittelbar übereinander vorgesehener Schaltungsmodule (2), insbesondere hinsichtlich ihrer Orientierung, ihrer geometrischen Abmessungen und/oder dergleichen, derart ausgebildet sind, um miteinander mechanisch und elektrisch kontaktiert zu werden, wobei insbesondere jeweils ein Verbindungselement (6) eines vertikal höher angeordneten ersten Schaltungsmoduls (2) mit seinem zweiten Ende (8) in Bereich einer Schulter (8a) oder im Bereich des zweiten Endes (8) des jeweils vertikal koinzidierenden Verbindungselements des vertikal direkt und unmittelbar darunter angeordneten zweiten Schaltungsmoduls (2) kontaktierbar ist.

22. Anordnung nach einem der vorangehenden Ansprüche,
**dadurch gekennzeichnet,**
**daß** der mechanische und elektrische Kontakt der Verbindungselemente (6) jeweils durch Lötung, Schweißung, insbesondere Laserschweißung, und/oder aufgrund eines Kraftschlusses mittels Federvorspannung, vorzugsweise im Bereich der zweiten Enden (8) der Verbindungselemente (6), ausbildbar ist.

23. Anordnung nach einem der vorangehenden Ansprüche,
**dadurch gekennzeichnet,**
**daß** ein Träger (14) vorgesehen ist, auf welchem das unterste in vertikaler Richtung übereinander angeordneter Schaltungsmodule (2) angeordnet, fixiert und/oder elektrisch kontaktiert ist.

24. Anordnung nach einem der vorangehenden Ansprüche,
**dadurch gekennzeichnet,**
**daß** eine Gehäuseeinrichtung (15), insbesondere in Form einer Vergußmasse, vorgesehen ist, in welcher zumindest die Schaltungsmodule (2) aufnehmbar sind.

25. Anordnung nach einem der vorangehenden Ansprüche,
**dadurch gekennzeichnet,**
**daß** zwischen jeweils zwei Schaltungsmodulen (2) jeweils ein Abstandselement (22) vorgesehen ist, welches insbesondere zur Entwärmung der Schaltungsmodule und/oder als Wärmesenke ausgebildet ist.
